# EUROPÄISCHE PATENTANMELDUNG

(11) **EP 4 242 681 A1**
(43) Veröffentlichungstag der Anmeldung: **13.09.2023**
(21) Anmeldenummer: 22161377.1
(22) Anmeldetag: 10.03.2022
(51) Int. Cl.: G01R 33/385

(54) **GRADIENTENSPULENEINHEIT UMFASSEND ZWEI HOHLZYLINDERBEREICHE FÜR EIN MAGNETRESONANZBILDGEBUNGSSYSTEM**

(71) Anmelder: Siemens Healthcare GmbH, 91052 Erlangen (DE)
(72) Erfinder: Dietz, Peter, 90762 Fürth (DE); Krug, Andreas, 90762 Fürth (DE); Körber, Simon, 91352 Hallerndorf (DE); Stocker, Stefan, 91091 Großenseebach (DE)

(57) **Zusammenfassung**

Die Erfindung betrifft eine Gradientenspuleneinheit (19) ausgebildet als Hohlzylinder umgebend eine Zylinderachse (z),
- begrenzt senkrecht zur Zylinderachse (z) durch ein erstes Längsende (z1) und ein dem gegenüberliegendes zweites Längsende (z2),
- aufweisend eine Länge entsprechend einer Distanz zwischen dem ersten Längsende (z1) und dem zweiten Längsende (z2) von zumindest 140 cm,
- umfassend eine Leiterstruktureinheit (40) ausgebildet zur Erzeugung von Magnetfeldgradienten in drei voneinander verschiedene Richtungen,
wobei der Hohlzylinder einen ersten Hohlzylinderbereich (51) und einen zweiten Hohlzylinderbereich (52), getrennt vom ersten Hohlzylinderbereich (51) durch eine Schnittebene (S) senkrecht zur Zylinderachse (z), umfasst,
der erste Hohlzylinderbereich (51) vom ersten Längsende (z1) und der zweite Hohlzylinderbereich (52) vom zweiten Längsende (z2) begrenzt wird und der erste Hohlzylinderbereich (51) frei von der Leiterstruktureinheit (40) ist.

## Beschreibung

Die Erfindung betrifft eine Gradientenspuleneinheit und ein Magnetresonanzgerät.

In einem Magnetresonanzgerät wird üblicherweise der zu untersuchende Körper eines Untersuchungsobjektes, insbesondere eines Patienten, in einem Patientenaufnahmebereich mit Hilfe eines Hauptmagneten einem relativ hohen Hauptmagnetfeld, beispielsweise von 1,5, 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse (HF-Pulse), insbesondere Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden. Das Untersuchungsobjekt ist zumindest teilweise innerhalb des Untersuchungsbereiches positioniert. Der Untersuchungsbereich ist typischerweise der räumliche Bereich, von dem Rohdaten akquiriert werden.

Eine Gradientenspuleneinheit ist typischerweise zur Erzeugung von Magnetfeldgradienten in zumindest zwei, vorzugsweise in drei, Richtungen ausgelegt. Hierfür weist die Gradientenspuleneinheit Leiterstrukturen auf. Die Gradientenspuleneinheit wird dabei mit elektrischen Strömen gesteuert, deren Amplituden mehrere 100 A erreichen und die häufigen und raschen Wechseln der Stromrichtung mit Anstiegs- und Abfallraten von mehreren 100 kA/s unterliegen. Aufgrund der Positionierung der Gradientenspuleneinheit innerhalb des Hauptmagneten des Magnetresonanzgerätes entsteht eine große Kraft, welche auf die Gradientenspuleneinheit wirkt. Mit der Kraft ist ein Drehmoment verknüpft, welches zu einer Bewegung und/oder einer Biegung der Gradientenspuleneinheit führen kann. Dies kann im Betrieb der Gradientenspuleneinheit zu Vibrationen führen. Die Leiterstrukturen sind typischerweise über ein Vergussmaterial miteinander verbunden und insbesondere derart vergossen, dass diese in einer festen Anordnung zueinanderstehen und typischerweise zusammen mit dem Vergussmaterial einen Hohlzylinder bilden. Vibrationen und/oder mechanische Kräfte können das Vergussmaterial und die Leiterstrukturen im Betrieb der Gradientenspuleneinheit zerstören.

Stärkere Magnetfeldgradienten und/oder Anstiegs- und Abfallraten ermöglichen typischerweise eine schnellere Aufnahme von Rohdaten und/oder eine höhere Auflösung von Bilddaten. Insbesondere bei Untersuchungen des Kopfes eines Untersuchungsobjektes, besonders bei diffusionsgewichteten Aufnahmen und/oder bei einer Verwendung eines Magnetresonanzgerätes mit einem Hauptmagnetfeld von mehr als 3 Tesla, sind besonders starke Magnetfeldgradienten von bis zu 250 mT/m mit Anstiegsund Abfallraten von bis zu 1000 T/s/m, in besonderen Fällen bis 2000 T/s/m, wünschenswert. Hier treten besonders hohe Kräfte auf, aus denen Vibrationen resultieren können. Insbesondere können dabei auch Eigenfrequenzen, also Resonanzfrequenzen, der Gradientenspuleneinheit angeregt werden, welche die Gradientenspuleneinheit in Schwingung versetzen und diese zerstören können. Herkömmlich werden verbotene Frequenzbereiche für die Anstiegs- und Abfallraten definiert, mit welchen die Gradientenspule nicht angesteuert werden darf, um derartige Schwingungen zu vermeiden.

DE 20 2020 100 449 beschreibt eine Vorrichtung zur Vermeidung von mechanischen Spannungen und mechanischen Grenzflächenschädigungen, wie beispielsweise Delaminationen aufgrund thermischer und chemischer Prozesse nach dem Vergießen, insbesondere beim Aushärten des Vergussmaterials. Andere Weiterentwicklungen für derartig leistungsstarke Gradientenspuleneinheiten betreffen eine verbesserte Streufeldkompensation, wie beispielsweise EP3561534, eine verbesserte Kraftkompensation, wie beispielsweise DE 10 2018 206 643, und/oder ein integriertes Shimming, wie beispielsweise DE 10 2017 213 026.

Der Erfindung liegt die Aufgabe zugrunde, eine besonders robuste und vibrationsarme Gradientenspuleneinheit anzugeben, insbesondere auch für Anstiegs- und Abfallraten von über 500 T/s/m. Die Aufgabe wird durch die Merkmale der unabhängigen Ansprüche gelöst. Vorteilhafte Ausgestaltungen sind in den Unteransprüchen beschrieben.

Die erfindungsgemäße Gradientenspuleneinheit ist als Hohlzylinder umgebend eine Zylinderachse ausgebildet und senkrecht zur Zylinderachse durch ein erstes Längsende und ein dem gegenüberliegendes zweites Längsende begrenzt. Die Gradientenspuleneinheit weist eine Länge entsprechend einer Distanz zwischen dem ersten Längsende und dem zweiten Längsende von zumindest 140 cm auf und umfasst eine Leiterstruktureinheit ausgebildet zur Erzeugung von Magnetfeldgradienten in drei voneinander verschiedene Richtungen. Der Hohlzylinder umfasst einen ersten Hohlzylinderbereich und einen zweiten Hohlzylinderbereich, welcher zweite Hohlzylinderbereich vom ersten Hohlzylinderbereich durch eine Schnittebene senkrecht zur Zylinderachse getrennt ist und der erste Hohlzylinderbereich vom ersten Längsende und der zweite Hohlzylinderbereich vom zweiten Längsende begrenzt wird. Der erste Hohlzylinderbereich ist frei von der Leiterstruktureinheit.

Die Leiterstruktureinheit umfasst vorzugsweise zumindest drei Leiterstrukturen, wobei sich die zumindest drei Leiterstrukturen jeweils voneinander in ihrem radialen Abstand zur Zylinderachse unterscheiden. Alle von der Leiterstruktureinheit umfassten Leiterstrukturen unterscheiden sich vorzugsweise jeweils voneinander in ihrem radialen Abstand zur Zylinderachse. Die drei voneinander verschiedenen Richtungen sind vorzugsweise orthogonal zueinander. Eine Leiterstruktur umfasst typischerweise einen elektrischen Leiter. Die geometrisehe Anordnung eines elektrischen Leiters kann als Leiterstruktur bezeichnet werden. Ein Magnetfeldgradient ist vorzugsweise ein Magnetfeldgradient erster Ordnung. Die Leiterstruktureinheit kann zumindest vier Leiterstrukturen umfassen, wobei zumindest zwei der zumindest vier Leiterstrukturen dazu ausgebildet sind, gemeinsam einen Magnetfeldgradienten in eine Richtung zu erzeugen. Die Stromquelle umfasst vorzugsweise eine Gradientenverstärkereinheit. Die Stromquelle ist vorzugsweise zur Erzeugung eines elektrischen Stromes von zumindest 700 A, bevorzugt von zumindest 900 A, besonders bevorzugt von zumindest 1100 A, ausgebildet. Die Gradientenspuleneinheit kann die Stromquelle umfassen.

Die Stromquelle ist vorzugsweise mit der Leiterstruktureinheit elektrisch verbunden, wobei die elektrische Verbindung vorzugsweise eine Zuleitung umfasst. Die elektrische Verbindung kann ein Gradientenanschlusskabel umfassen, welches außerhalb der hohlförmigen Gradientenspuleneinheit angeordnet ist und/oder an von der Gradientenspuleneinheit umfasste Gradientenanschlüsse anschließt. Die Zuleitung ist vorzugsweise räumlich in die Gradientenspuleneinheit integriert. Die Zuleitung verbindet die Leiterstruktureinheit vorzugsweise direkt mit einem Gradientenanschluss. Die Funktion der Zuleitung beschränkt sich vorzugsweise auf die Weiterleitung des elektrischen Stromes an die Leiterstruktureinheit. Ein elektrischer Strom in der Zuleitung trägt typischerweise nicht zur räumlichen Erzeugung und/oder Ausgestaltung eines von der Leiterstruktureinheit erzeugten Magnetfeldgradienten bei.

Die Außenform der Gradientenspuleneinheit ist typischerweise hohlzylinderförmig. Die Länge der Gradientenspuleneinheit entlang der Zylinderachse beträgt typischerweise zumindest 140 cm, bevorzugt zumindest 150 cm, besonders bevorzugt zumindest 155 cm. Die Länge der Gradientenspuleneinheit entlang der Zylinderachse beträgt typischerweise höchstens 200 cm, bevorzugt höchstens 175 cm, besonders bevorzugt höchstens 165 cm. Die Länge des zweiten Hohlzylinderbereichs parallel zur Zylinderachse beträgt typischerweise zumindest 100 cm, bevorzugt zumindest 110 cm, besonders bevorzugt zumindest 120 cm. Die Länge des zweiten Hohlzylinderbereichs parallel zur Zylinderachse beträgt typischerweise höchstens 150 cm, bevorzugt höchstens 140 cm, besonders höchstens zumindest 130 cm.

Die Gradientenspuleneinheit wird vorzugsweise durch zwei entlang der Zylinderachse konsekutiv angeordnete Hohlzylinderbereiche, insbesondere dem ersten Hohlzylinderbereich und dem zweiten Hohlzylinderbereich, gebildet. Der Außenradius des ersten Hohlzylinderbereiches entspricht vorzugsweise dem Außenradius des zweiten Hohlzylinderbereiches. Die radiale räumliche Ausdehnung, insbesondere die Wanddicke, des ersten Hohlzylinderbereiches entspricht vorzugsweise der radialen räumlichen Ausdehnung des zweiten Hohlzylinderbereiches. Der zweite Hohlzylinderbereich weist entlang der Zylinderachse typischerweise eine größere räumliche Ausdehnung, insbesondere Länge, auf, als der erste Hohlzylinderbereich. Der erste Hohlzylinderbereich ist typischerweise frei von einem elektrischen Leiter und/oder frei von elektrisch leitfähigem Material und/oder der Zuleitung. Der erste Hohlzylinderbereich kann alternativ die Zuleitung umfassen. Die radiale räumliche Ausdehnung der ersten Hohlzylinderbereiches und/oder des zweiten Hohlzylinderbereiches beträgt bevorzugt weniger als 200 mm, besonders bevorzugt weniger als 190 mm.

Der erste Hohlzylinderbereich ermöglicht eine Versteifung der Gradientenspuleneinheit, sodass resultierende Kräfte und Vibrationen im Betrieb der Gradientenspuleneinheit reduziert werden. Die Tatsache, dass der erste Hohlzylinderbereich frei von der Leiterstruktureinheit und damit vorzugsweise frei von elektrischen Strömen und daraus resultierenden Kräften ist, ermöglicht eine besonders effiziente Änderung der Eigenfrequenz. Insbesondere kann der erste Hohlzylinderbereich die Eigenfrequenz bestimmter Schwingungsmoden der Gradientenspuleneinheit derart erhöhen, dass diese im Betrieb der Gradientenspuleneinheit nicht mehr angeregt werden können. Zusätzlich können dadurch die verbotenen Frequenzbereiche der Gradientenspuleneinheit reduziert werden, was ein breiteres Anwendungsspektrum ermöglicht. Durch entsprechende Wahl der Größe und des Materials des ersten Hohlzylinderbereiches können die Eigenfrequenzen und/oder Schwingungsmoden der Gradientenspuleneinheit modifiziert und kontrolliert werden. Insbesondere können die Eigenfrequenzen derart konsolidiert werden, dass diese von einem möglichst schmalen verbotenen Frequenzbereich abgedeckt werden können. Durch entsprechende Wahl der Größe und des Materials des ersten Hohlzylinderbereich können Schwingungsamplituden reduziert werden.

Eine Ausführungsform der Gradientenspuleneinheit sieht vor, dass der erste Hohlzylinderbereich eine Länge von zumindest 25 cm parallel zur Zylinderachse aufweist. Die Länge des ersten Hohlzylinderbereich parallel zur Zylinderachse beträgt typischerweise zwischen 25 cm und 60 cm, vorzugsweise zwischen 30 cm und 50 cm, besonders bevorzugt zwischen 35 cm und 45 cm. Eine derartige Länge des ersten Hohlzylinderbereich ermöglicht ausreichend Volumen zur Versteifung der Gradientenspuleneinheit, wobei gleichzeitig der Patientenaufnahmebereich, welcher innerhalb des Hohlzylinders angeordnet ist, nicht unnötig verlängert wird. Dies ist insbesondere für klaustrophobische Patienten vorteilhaft.

Eine Ausführungsform der Gradientenspuleneinheit sieht vor, dass der zweite Hohlzylinderbereich die Leiterstruktureinheit vollständig umfasst. Die Leiterstruktureinheit ist nach dieser Ausführungsform auf den zweiten Hohlzylinderbereich konzentriert und ermöglicht eine besonders effiziente Versteifung der Gradientenspuleneinheit durch den ersten Hohlzylinderbereich, von welchem keine Kräfte und/oder Vibrationen aktiv erzeugt werden. Vielmehr ist der erste Hohlzylinderbereich derart gestaltet, dass Kräfte und/oder eine Krafteinkopplung minimiert und dadurch die Anregung und damit die Vibrationsamplitude bestimmter Moden reduziert wird.

Eine Ausführungsform der Gradientenspuleneinheit sieht vor, dass die Leiterstruktureinheit von Vergussmasse, insbesondere von Epoxidharz, umgeben ist. Die Leiterstruktureinheit ist vorzugsweise vollständig von der Vergussmasse umschlossen. Die Vergussmasse wird typischerweise vom zweiten Hohlzylinderbereich umfasst. Die Leiterstruktureinheit ist typischerweise durch die Vergussmasse geschützt. Die Oberfläche der Vergussmasse entspricht vorzugsweise der Oberfläche der Gradientenspuleneinheit und/oder des zweiten Hohlzylinderbereiches. Dies ermöglicht einen besonders guten Schutz und Isolierung der Leiterstruktur. Zudem ermöglicht die Vergussmasse einen guten Ausgleich zwischen Flexibilität und Steifigkeit zur Absorption von Kräften.

Eine Ausführungsform der Gradientenspuleneinheit sieht vor, dass der erste Hohlzylinderbereich versteifende Fasern umfasst. Der erste Hohlzylinderbereich umfasst vorzugsweise zumindest teilweise ein versteifendes Material, welches versteifende Fasern umfasst. Die versteifenden Fasern können nur in einem Teilbereich des ersten Hohlzylinderbereiches angeordnet sein, wobei der Bereich des ersten Hohlzylinderbereichs außerhalb des Teilbereiches die gleiche Vergussmasse vorsieht, von welcher Vergussmasse auch die Leiterstruktureinheit im zweiten Hohlbereich umgeben ist. Der Teilbereich umfasst vorzugsweise das versteifende Material. Der Anteil des Volumens der versteifenden Fasern am Volumen des Teilbereiches beträgt typischerweise zwischen 60% und 80%, bevorzugt zwischen 65% uns 75%, besonders bevorzugt zwischen 68% und 72%. Der zweite Hohlzylinderbereich ist vorzugsweise frei von versteifenden Fasern. Der zweite Hohlzylinderbereich kann versteifende Fasern umfassen, wobei der Anteil der versteifenden Fasern im zweiten Hohlzylinderbereich geringer ist als der Anteil der versteifenden Fasern im ersten Hohlzylinderbereich. Die versteifenden Fasern mindern typischerweise die Flexibilität und/oder erhöhen die Steifigkeit der Gradientenspuleneinheit. Dies bewirkt eine Reduktion von Amplituden aufgrund von Schwingungen der Gradientenspuleneinheit, insbesondere bei einer Eigenfrequenz. Ebenso werden Spannungen in dem ersten Hohlzylinderbereich und/oder dem zweiten Hohlzylinderbereich und/oder in einem davon umfassten Material reduziert. Dies erhöht insbesondere die Robustheit der Gradientenspuleneinheit und schützt diese vor Zerstörung, insbesondere auch bei Anstiegs- und Abfallraten von über 500 T/s/m.

Eine Ausführungsform der Gradientenspuleneinheit sieht vor, dass sich eine Dichte der Vergussmasse und eine Dichte der versteifenden Fasern und/oder des versteifenden Materials umfassend die versteifenden Fasern um höchstens 5%, bevorzugt um höchstens 2%, besonders bevorzugt um höchstens 1% unterscheidet. Die Dichte der Vergussmasse entspricht vorzugsweise der Dichte der versteifenden Fasern und/oder der Dichte des versteifenden Materials umfassend die versteifenden Fasern. Eine derartige Wahl der versteifenden Fasern und/oder des versteifenden Materials ermöglicht, dass sich die Dichte innerhalb des ersten Hohlzylinderbereiches und/oder am Übergang zwischen erstem Hohlzylinderbereich und zweitem Hohlzylinderbereich, also in der Schnittebene, nicht oder nur geringfügig ändert und somit die versteifenden Fasern lediglich die Eigenfrequenz und/oder die Schwingungsmoden beeinflussen. Im Vergleich zu einem ersten Hohlzylinderbereich aus Vergussmaterial frei von versteifenden Fasern sind globale Moden unverändert. Dies erhöht die Kompatibilität mit herkömmlichen Gradientenspuleneinheiten.

Eine Ausführungsform der Gradientenspuleneinheit sieht vor, dass die Steifigkeit der versteifenden Fasern zumindest doppelt so hoch ist wie die Steifigkeit der Vergussmasse. Die Steifigkeit der versteifenden Fasern beträgt typischerweise zwischen 25 GPa und 45 GPa, bevorzugt zwischen 30 GPa und 40 GPa, besonders bevorzugt zwischen 32 GPa und 36 GPa. Die Steifigkeit der Vergussmasse beträgt typischerweise zwischen 5 GPa und 20 GPa, bevorzugt zwischen 8 GPa und 16 GPa, besonders bevorzugt zwischen 10 GPa und 14 GPa. Die Steifigkeit der versteifenden Fasern ist bevorzugt zumindest 2,5-mal, besonders bevorzugt zumindest dreimal so hoch wie die Steifigkeit der Vergussmasse. Die Steifigkeit der versteifenden Fasern ist bevorzugt höchstens sechsmal, besonders bevorzugt zumindest fünfmal so hoch wie die Steifigkeit der Vergussmasse. Dies vergrößert den linearen Bereich der Rückstellkräfte, wodurch die Eigenfrequenz besonders effizient veränderbar ist.

Eine Ausführungsform der Gradientenspuleneinheit sieht vor, dass die versteifenden Fasern an der zur Zylinderachse gerichteten Innenseite und/oder an der von der Zylinderachse abgewandten Außenseite von der Vergussmasse bedeckt sind. Der erste Hohlzylinderbereich umfasst demnach vorzugsweise versteifende Fasern und Vergussmasse, wobei die versteifenden Fasern mit der Vergussmasse vergossen sein können. Die versteifenden Fasern können nur in einem Teilbereich des ersten Hohlzylinderbereiches angeordnet sein, wobei der Bereich des ersten Hohlzylinderbereichs außerhalb des Teilbereiches die gleiche Vergussmasse vorsieht, von welcher Vergussmasse auch die Leiterstruktureinheit im zweiten Hohlbereich umgeben ist. Umfasst der erste Hohlzylinderbereich versteifende Fasern und Vergussmasse, so kann der Übergang zwischen erstem Hohlzylinderbereich und zweitem Hohlzylinderbereich besonders kontinuierlich ausgestaltet sein. Dies kann die Stabilität der Gradientenspuleneinheit erhöhen. Der die versteifenden Fasern umfassende Teilbereich des ersten Hohlzylinderbereichs ist vorzugsweise hohlzylinderförmig und/oder frei von Vergussmasse. Dieser Teilbereich ist vorzugsweise an der zur Zylinderachse gerichteten Innenseite und an der von der Zylinderachse abgewandten Außenseite von der Vergussmasse bedeckt. Dies ermöglicht eine kontinuierliche Oberflächenbeschaffenheit der Gradientenspuleneinheit, welche dadurch besonders robust wird. Der die versteifenden Fasern umfassende Teilbereich des ersten Hohlzylinderbereichs kann auch Teil der von der Zylinderachse abgewandten Außenseite sein, sodass der erste Hohlzylinderbereich an der Innenseite Vergussmasse und an der Außenseite versteifende Fasern umfasst. Dies ist besonders vorteilhaft, da an der der Zylinderachse abgewandten Außenseite der Gradientenspuleneinheit besonders hohe Kräfte wirken und eine Versteifung dieser besonders effizient wirkt.

Eine Ausführungsform der Gradientenspuleneinheit sieht vor, dass die versteifenden Fasern in Umfangsrichtung des ersten Hohlzylinderbereiches ausgerichtet sind, insbesondere tangential wirken. Dies ermöglicht eine besonders effiziente Erhöhung der Steifigkeit und Reduktion der radialen Kräfte, insbesondere eine reduzierte Krafteinkopplung, wodurch Schwingungen besonders gut verhindert werden können.

Eine Ausführungsform der Gradientenspuleneinheit sieht vor, dass eine radiale räumliche Ausdehnung der versteifenden Fasern zumindest 20%, bevorzugt zumindest 30%, besonders bevorzugt zumindest 40% einer radialen räumlichen Ausdehnung des ersten Hohlzylinderbereiches entspricht. Ein die versteifenden Fasern umfassender Teilbereich des ersten Hohlzylinderbereichs ist vorzugsweise hohlzylinderförmig, wobei die radiale räumliche Ausdehnung, also die Wanddicke des Teilbereiches vorzugsweise weniger als halb so groß wie die Wanddicke des ersten Hohlzylinderbereiches ist.

Die radiale räumliche Ausdehnung der versteifenden Fasern beträgt typischerweise höchstens 80%, bevorzugt höchstens 65%, besonders bevorzugt höchstens 50% einer radialen räumlichen Ausdehnung des ersten Hohlzylinderbereiches.

Ein derartiger erster Hohlzylinderbereich ist besonders stabil, erhöht Eigenfrequenzen und reduziert Amplituden von Resonanzen.

Eine Ausführungsform der Gradientenspuleneinheit sieht vor, dass die versteifenden Fasern zumindest eines der folgenden Materialien umfassen:
- Glas
- Carbon
- glasfaserverstärkter Kunststoff (GFK).

Derartige Materialien sind gut zu verarbeiten und weisen eine vorteilhafte Dichte und Steifigkeit auf, sodass die Eigenfrequenzen der Gradientenspuleneinheit effizient verändert werden können, insbesondere in Kombination mit Epoxidharz als Vergussmasse. Insbesondere kann auch eine Mischung dieser Materialien verwendet werden, wodurch eine vielseitige Beeinflussung der Eigenfrequenzen der Gradientenspuleneinheit möglich ist.

Eine Ausführungsform der Gradientenspuleneinheit sieht vor, dass die Leiterstruktureinheit zumindest fünf Leiterstrukturen mit jeweils unterschiedlichen radialen Abständen zur Zylinderachse umfasst. Eine erste Leiterstruktur und eine zweite Leiterstruktur der zumindest fünf Leiterstrukturen sind gemeinsam zu einer Erzeugung eines Magnetfeldgradienten in eine erste Richtung der drei Richtungen ausgebildet. Eine dritte Leiterstruktur der zumindest fünf Leiterstrukturen ist zu einer Kompensation eines bei Erzeugung eines Magnetfeldgradienten mittels erster Leiterstruktur und/oder zweiter Leiterstruktur entstehenden Streumagnetfeldes ausgebildet.

Die erste Leiterstruktur ist in Längsrichtung, also parallel zur Zylinderachse, vorzugsweise kürzer als die zweite Leiterstruktur und die dritte Leiterstruktur. Die dritte Leiterstruktur umgibt die zweite Leiterstruktur vorzugsweise zumindest teilweise radial und die zweite Leiterstruktur umgibt die erste Leiterstruktur vorzugsweise zumindest teilweise radial. Die erste Leiterstruktur und/oder die zweite Leiterstruktur sind vorzugsweise zu einer Kompensation eines bei einer Erzeugung des Magnetfeldgradienten in die erste Richtung entstehenden Drehmomentes auf die Gradientenspuleneinheit ausgebildet. Die Gradientenspuleneinheit ist vorzugsweise flexibel innerhalb eines Patientenaufnahmebereiches eines Magnetresonanzgerätes positionierbar und/oder als lokale Gradientenspuleneinheit ausgebildet.

Eine vierte Leiterstruktur der zumindest fünf Leiterstrukturen kann alleine oder gemeinsam mit einer weiteren Leiterstruktur zu einer Erzeugung eines Magnetfeldgradienten in eine zweite Richtung der drei Richtungen ausgebildet sein. Eine fünfte Leiterstruktur der zumindest fünf Leiterstrukturen kann alleine oder gemeinsam mit einer weiteren Leiterstruktur zu einer Erzeugung eines Magnetfeldgradienten in eine dritte Richtung der drei Richtungen ausgebildet sein.

Die Anordnung und die Funktionsweise der Leiterstrukturen kann insbesondere der in DE 10 2018 206 643 beschriebenen Gradientenspuleneinheit entsprechen.

Eine derartige Gradientenspuleneinheit ist zu einer Erzeugung besonders hoher Magnetfeldgradienten ausgebildet und verfügt bereits durch die Verwendung der ersten Leiterstruktur und der zweiten Leiterstruktur eine Möglichkeit zur Kraftkompensation. Der erste Hohlzylinderbereich frei von der Leiterstruktureinheit bewirkt eine weitere Stabilisierung einer derartigen Gradientenspuleneinheit und ermöglicht einen sicheren Betrieb.

Eine Ausführungsform der Gradientenspuleneinheit sieht vor, dass die Leiterstruktureinheit zu jeder Ebene senkrecht zur Zylinderachse asymmetrisch ausgebildet ist. Insbesondere lokale Gradientenspuleneinheiten ausgebildet zur Aufnahme des Kopfes eines Untersuchungsobjektes ermöglichen bei entsprechend asymmetrischer Wahl der Leiterstruktureinheit eine besonders hohe Amplitude und besonders hohe Anstiegs- und Abfallraten, sodass eine Versteifung der Gradientenspuleneinheit durch Verwendung des ersten Hohlzylinderbereiches besonders vorteilhaft ist.

Eine Ausführungsform der Gradientenspuleneinheit sieht vor, dass eine radiale räumliche Ausdehnung des ersten Hohlzylinderbereiches geringer als eine radiale räumliche Ausdehnung des zweiten Hohlzylinderbereiches ist. Insbesondere bei Ausbildung der Gradientenspuleneinheit als lokale Gradientenspuleneinheit ausgebildet lediglich zur Aufnahme eines Kopfes eines Untersuchungsobjektes ist es vorteilhaft, wenn die Gradientenspuleneinheit am ersten Längsende einen größeren Innenradius aufweist als am zweiten Längsende. Dies ermöglicht eine bequeme Lagerung des Untersuchungsobjektes innerhalb der Gradientenspuleneinheit, da der Schulterbereich des Untersuchungsobjektes innerhalb des ersten Hohlzylinderbereiches mit dem größeren Innenradius gelagert werden kann. Der Kopfbereich des Untersuchungsobjektes, welcher typischerweise kleiner als dessen Schulterbereich ist, ist innerhalb des zweiten Hohlzylinderbereiches mit geringerem Innenradius anzuordnen. Auch bei Gradientenspuleneinheiten ausgebildet zur Aufnahme eines gesamten Körpers eines Untersuchungsobjektes ist eine derartige Ausführungsform vorteilhaft, da ein auch nur teilweise größerer Patientenaufnahmebereich den Komfort des Patienten erhöht. Da im ersten Hohlzylinderbereich auf Leiterstrukturen und entsprechende Kühlung verzichtet werden kann, kann die radiale räumliche Ausdehnung ohne Verlust geringer ausgebildet sein.

Des Weiteren geht die Erfindung aus von einem Magnetresonanzgerät umfassend einen Hauptmagneten, einen Shimkäfig ausgebildet zur Aufnahme von Shimeisen, eine Hochfrequenzspuleneinheit und eine erfindungsgemäße Gradientenspuleneinheit, wobei der Shimkäfig zwischen dem Hauptmagneten und der Gradientenspuleneinheit angeordnet ist und die Gradientenspule an zumindest einer radialen Position parallel zur Zylinderachse eine größere Länge aufweist als der Shimkäfig.

Der Hauptmagnet ist vorzugsweise dazu ausgebildet, ein Hauptmagnetfeld von zumindest 3 Tesla, besonders bevorzugt von zumindest 7 Tesla zu erzeugen. Der Hauptmagnet ist vorzugsweise hohlzylinderförmig ausgebildet. Der Shimkäfig ist vorzugsweise hohlzylinderförmig ausgebildet und im zumindest teilweise vom Hauptmagneten umschlossenen Bereich angeordnet. Die Gradientenspuleneinheit ist vorzugsweise im zumindest teilweise vom Shimkäfig umschlossenen Bereich angeordnet. Der Shimkäfig ist typischerweise zwischen Hauptmagnet und Gradientenspuleneinheit angeordnet.

Shimeisen sind typischerweise Platten und/oder Formen aus Metall, insbesondere aus Eisen. Shimeisen werden typischerweise im Rahmen der Installation des Magnetresonanzgerätes an definierten Positionen an der hohlzylindrischen Innenseite des Hauptmagneten zur Homogenisierung des Hauptmagnetfeldes angeordnet. Der Shimkäfig kann Metall und/oder GFK umfassen. Die Außenfläche der Gradientenspuleneinheit ist typischerweise berührungsfrei zur Innenseite des Shimkäfigs angeordnet und von diesem entkoppelt, beispielsweise durch Sylomer. Insbesondere kann eine Lagerungshilfe ausgebildet zur Unterstützung der Lagerung der Gradientenspuleneinheit innerhalb des Shimkäfigs Sylomer umfassen. Ist die Länge der Gradientenspuleneinheit an zumindest einer radialen Position zumindest so groß wie die Länge des Shimkäfigs parallel zur Zylinderachse, so kann die Gradientenspuleneinheit vom Shimkäfig besonders gut entkoppelt werden. Insbesondere kann der erste Hohlzylinderbereich die Gradientenspuleneinheit zusätzlich stabilisieren.

Ausführungsformen des erfindungsgemäßen Magnetresonanzgerätes sind analog zu den Ausführungsformen der erfindungsgemäßen Gradientenspuleneinheit ausgebildet. Die Vorteile des erfindungsgemäßen Magnetresonanzgeräts entsprechen im Wesentlichen den Vorteilen der erfindungsgemäßen Gradientenspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: ein erfindungsgemäßes Magnetresonanzgerät in einer schematischen Darstellung,
- Fig. 2: eine erfindungsgemäße Gradientenspuleneinheit in einer ersten Ausführungsform in einer schematischen Darstellung,
- Fig. 3: einen ersten Hohlzylinderbereich einer zweiten Ausführungsform in einer schematischen Darstellung, und
- Fig. 4: eine erfindungsgemäße Gradientenspuleneinheit in einer dritten Ausführungsform in einer schematischen Darstellung.

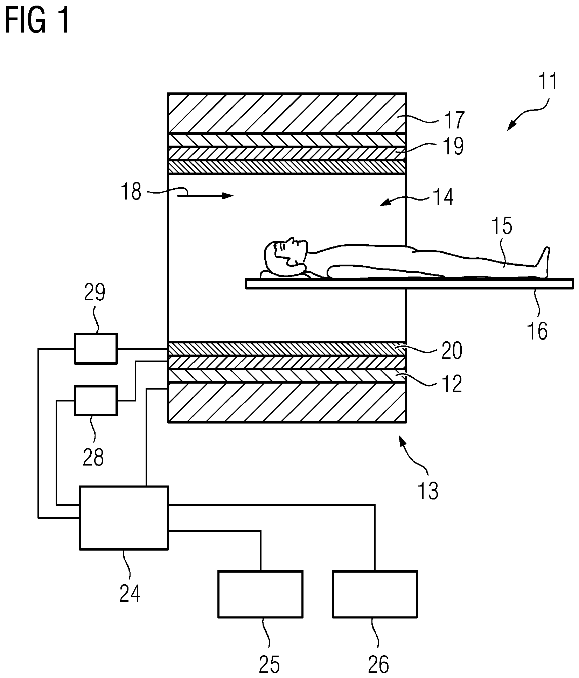

Figur 1 zeigt ein erfindungsgemäßes Magnetresonanzgerät 11 in einer schematischen Darstellung. Das Magnetresonanzgerät 11 umfasst eine Detektoreinheit 13 mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Detektoreinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist.

Die Detektoreinheit 13 umfasst eine erfindungsgemäße Gradientenspuleneinheit 19, die für eine Ortskodierung während einer Bildgebung verwendet wird. Die Gradientenspuleneinheit 19 wird mittels einer Gradientensteuereinheit 28 angesteuert. Die Gradientensteuereinheit 28 umfasst typischerweise eine Stromquelle. Die Detektoreinheit 13 umfasst einen Shimkäfig 12, welcher zur Aufnahme von Shimeisen ausgebildet ist. Der Shimkäfig 12 ist typischerweise zwischen Gradientenspuleneinheit 19 und Hauptmagnet 17 angeordnet. Die Länge der Gradientenspuleneinheit 19 parallel zum Hauptmagnetfeld 18 ist vorzugsweise größer als die Länge des Shimkäfigs 12. Des Weiteren weist die Detektoreinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

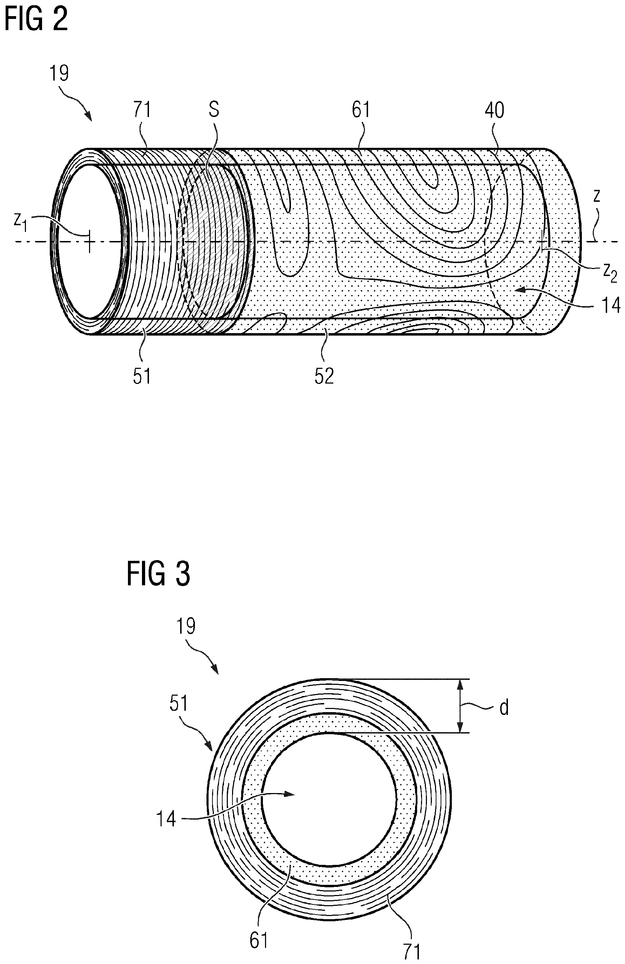

Figur 2 zeigt eine erfindungsgemäße Gradientenspuleneinheit 19 in einer ersten Ausführungsform in einer schematischen Darstellung. Die Gradientenspuleneinheit 19 ist ausgebildet als Hohlzylinder umgebend eine Zylinderachse z, wobei diese senkrecht zur Zylinderachse z durch ein erstes Längsende z1 und ein dem gegenüberliegendes zweites Längsende z2 begrenzt ist. Die Distanz zwischen dem ersten Längsende z1und dem zweiten Längsende z2 beträgt zumindest 140 cm. Die Gradientenspuleneinheit 19 umfasst eine Leiterstruktureinheit 40 ausgebildet zur Erzeugung von Magnetfeldgradienten in drei voneinander verschiedene Richtungen. Der Hohlzylinder umfasst einen ersten Hohlzylinderbereich 51 und einen zweiten Hohlzylinderbereich 52, welcher vom ersten Hohlzylinderbereich durch eine Schnittebene S senkrecht zur Zylinderachse z getrennt ist,
wobei der erste Hohlzylinderbereich 51 vom ersten Längsende z1und der zweite Hohlzylinderbereich 52 vom zweiten Längsende z2 begrenzt wird. Der erste Hohlzylinderbereich 51 ist frei von der Leiterstruktureinheit 40. Der zweite Hohlzylinderbereich 52 umfasst die Leiterstruktureinheit 40 vollständig. Die Leiterstruktureinheit 40 ist von einer Vergussmasse 61 umgeben. Die Leiterstruktureinheit 40 ist asymmetrisch zu jeder Ebene senkrecht zur Zylinderachse z, also asymmetrisch zu jeder Ebene parallel zur Schnittebene S, ausgebildet. Der Abstand vom ersten Längsende z1 zur Schnittebene S beträgt vorzugsweise zumindest 25 cm. Der erste Hohlzylinderbereich 51 umfasst versteifende Fasern 71, welche in Umfangsrichtung des ersten Hohlzylinderbereiches 51 ausgerichtet sind.

Figur 3 zeigt einen ersten Hohlzylinderbereich 51 einer zweiten Ausführungsform in einer schematischen Darstellung in einer Ebene parallel zur Schnittebene S. In dieser Ausführungsform sind die versteifenden Fasern 71 an der zur Zylinderachse z gerichteten Innenseite von der Vergussmasse 61 bedeckt und die radiale räumliche Ausdehnung der versteifenden Fasern 71 entspricht zumindest 20% einer radialen räumlichen Ausdehnung des ersten Hohlzylinderbereiches 51, welche auch als Wanddicke d zu bezeichnen ist.

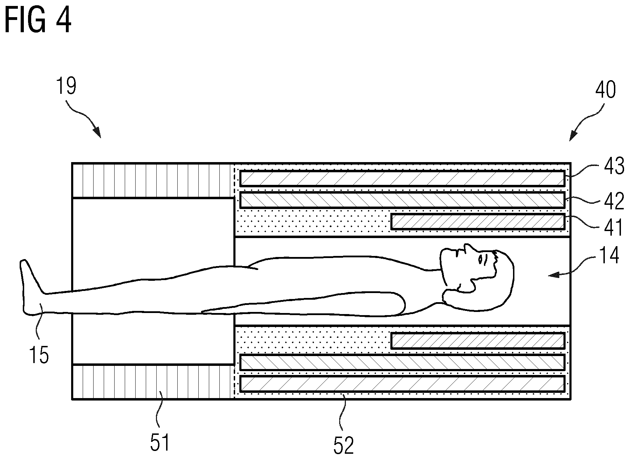

Figur 4 zeigt eine erfindungsgemäße Gradientenspuleneinheit 19 in einer dritten Ausführungsform in einer schematischen Darstellung. Die radiale räumliche Ausdehnung des ersten Hohlzylinderbereiches 51 ist geringer als die radiale räumliche Ausdehnung des zweiten Hohlzylinderbereiches 52.

Die Leiterstruktureinheit 40 umfasst zumindest fünf Leiterstrukturen wovon der besseren Erkennbarkeit lediglich drei der zumindest fünf Leiterstrukturen 41, 42, 43 dargestellt sind. Die zumindest fünf Leiterstrukturen 41, 42, 43 weisen jeweils einen unterschiedlichen radialen Abstand zur Zylinderachse z auf.

Eine erste Leiterstruktur 41 und eine zweite Leiterstruktur 42 der zumindest fünf Leiterstrukturen 41, 42, 43 sind gemeinsam zu einer Erzeugung eines Magnetfeldgradienten in eine erste Richtung der drei Richtungen ausgebildet. Eine dritte Leiterstruktur 43 der zumindest fünf Leiterstrukturen 41, 42, 43 ist zu einer Kompensation eines bei Erzeugung eines Magnetfeldgradienten wirkend in die erste Richtung mittels erster Leiterstruktur und/oder zweiter Leiterstruktur entstehenden Streumagnetfeldes ausgebildet. Die Leiterstruktureinheit 40 umfasst vorzugsweise drei weitere Leiterstrukturen, wobei zwei der drei weiteren Leiterstrukturen gemeinsam zu einer Erzeugung eines Magnetfeldgradienten in eine zweite Richtung der drei Richtungen ausgebildet sind. Eine dritte der drei weiteren Leiterstrukturen ist zu einer Kompensation eines bei Erzeugung eines Magnetfeldgradienten wirkend in zweiter Richtung entstehenden Streumagnetfeldes ausgebildet. Die erste Richtung entspricht vorzugsweise der x-Richtung oder der y-Richtung. Die zweite Richtung entspricht vorzugsweise der x-Richtung oder der y-Richtung. Die erste Richtung ist vorzugsweise orthogonal zur zweiten Richtung. Die Leiterstruktureinheit 40 umfasst typischerweise zusätzlich zumindest eine z-Leiterstruktur ausgebildet zur Erzeugung eines Magnetfeldgradienten in z-Richtung. Die Leiterstruktureinheit 40 umfasst typischerweise zusätzlich zumindest eine z-Schirm-Leiterstruktur ausgebildet zu einer Kompensation eines bei Erzeugung eines Magnetfeldgradienten in z-Richtung entstehenden Streumagnetfeldes. Alle von der Leiterstruktureinheit 40 umfassten Leiterstrukturen, insbesondere umfassend die z-Leiterstruktur und die z-Schirm-Leiterstruktur, unterscheiden sich jeweils voneinander zumindest in ihrem radialen Abstand zur Zylinderachse z.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Gradientenspuleneinheit ausgebildet als Hohlzylinder umgebend eine Zylinderachse,
- begrenzt senkrecht zur Zylinderachse durch ein erstes Längsende und ein dem gegenüberliegendes zweites Längsende,
- aufweisend eine Länge entsprechend einer Distanz zwischen dem ersten Längsende und dem zweiten Längsende von zumindest 140 cm,
- umfassend eine Leiterstruktureinheit ausgebildet zur Erzeugung von Magnetfeldgradienten in drei voneinander verschiedene Richtungen,
wobei der Hohlzylinder einen ersten Hohlzylinderbereich und einen zweiten Hohlzylinderbereich, getrennt vom ersten Hohlzylinderbereich durch eine Schnittebene senkrecht zur Zylinderachse, umfasst,
der erste Hohlzylinderbereich vom ersten Längsende und der zweite Hohlzylinderbereich vom zweiten Längsende begrenzt wird und der erste Hohlzylinderbereich frei von der Leiterstruktureinheit ist.

2. Gradientenspuleneinheit nach Anspruch 1,
wobei der erste Hohlzylinderbereich eine Länge von zumindest 25 cm parallel zur Zylinderachse aufweist.

3. Gradientenspuleneinheit nach einem der vorangehenden Ansprüche,
wobei der zweite Hohlzylinderbereich die Leiterstruktureinheit vollständig umfasst.

4. Gradientenspuleneinheit nach einem der vorangehenden Ansprüche,
wobei die Leiterstruktureinheit von Vergussmasse, insbesondere von Epoxidharz, umgeben ist.

5. Gradientenspuleneinheit nach einem der vorangehenden Ansprüche,
wobei der erste Hohlzylinderbereich versteifende Fasern umfasst.

6. Gradientenspuleneinheit nach den Ansprüchen 4 und 5, wobei sich eine Dichte der Vergussmasse und eine Dichte der versteifenden Fasern um höchstens 5% unterscheidet.

7. Gradientenspuleneinheit nach Anspruch 4 und nach einem der Ansprüche 5 bis 6,
wobei die Steifigkeit der versteifenden Fasern zumindest doppelt so hoch ist wie die Steifigkeit der Vergussmasse.

8. Gradientenspuleneinheit nach Anspruch 4 und nach einem der Ansprüche 5 bis 7,
wobei die versteifenden Fasern an der zur Zylinderachse gerichteten Innenseite und/oder an der von der Zylinderachse abgewandten Außenseite von der Vergussmasse bedeckt sind.

9. Gradientenspuleneinheit nach einem der Ansprüche 5 bis 8, wobei die versteifenden Fasern in Umfangsrichtung des ersten Hohlzylinderbereiches ausgerichtet sind.

10. Gradientenspuleneinheit nach einem der Ansprüche 5 bis 9, wobei eine radiale räumliche Ausdehnung der versteifenden Fasern zumindest 20% einer radialen räumlichen Ausdehnung des ersten Hohlzylinderbereiches entspricht.

11. Gradientenspuleneinheit nach einem der Ansprüche 5 bis 10,
wobei die versteifenden Fasern zumindest eines der folgenden Materialien umfassen:
- Glas
- Carbon
- glasfaserverstärkter Kunststoff (GFK).

12. Gradientenspuleneinheit nach einem der vorangehenden Ansprüche,
wobei die Leiterstruktureinheit zu jeder Ebene senkrecht zur Zylinderachse asymmetrisch ausgebildet ist.

13. Gradientenspuleneinheit nach einem der vorangehenden Ansprüche,
wobei die Leiterstruktureinheit
zumindest fünf Leiterstrukturen mit jeweils unterschiedlichen radialen Abständen zur Zylinderachse umfasst, wobei eine erste Leiterstruktur und eine zweite Leiterstruktur der zumindest fünf Leiterstrukturen gemeinsam zu einer Erzeugung eines Magnetfeldgradienten in eine erste Richtung der drei Richtungen
und eine dritte Leiterstruktur der zumindest fünf Leiterstrukturen zu einer Kompensation eines bei Erzeugung eines Magnetfeldgradienten mittels erster Leiterstruktur und/oder zweiter Leiterstruktur entstehenden Streumagnetfeldes ausgebildet sind.

14. Gradientenspuleneinheit nach einem der vorangehenden Ansprüche,
wobei eine radiale räumliche Ausdehnung des ersten Hohlzylinderbereiches geringer als eine radiale räumliche Ausdehnung des zweiten Hohlzylinderbereiches ist.

15. Magnetresonanzgerät umfassend einen Hauptmagneten, einen Shimkäfig ausgebildet zur Aufnahme von Shimeisen, eine Hochfrequenzspuleneinheit und eine Gradientenspuleneinheit nach einem der vorangehenden Ansprüche,
wobei der Shimkäfig zwischen dem Hauptmagneten und der Gradientenspuleneinheit angeordnet ist und die Gradientenspule an zumindest einer radialen Position parallel zur Zylinderachse eine größere Länge aufweist als der Shimkäfig.
